# EUROPÄISCHE PATENTANMELDUNG

(11) **EP 2 645 388 A2**
(43) Veröffentlichungstag der Anmeldung: **02.10.2013**
(21) Anmeldenummer: 12197932.2
(22) Anmeldetag: 19.12.2012
(51) Int. Cl.: H01H 9/22, H02B 1/38

(54) **Verriegelungsvorrichtung mit Türabfrage**

(30) Priorität: 30.03.2012 DE 102012205234
(71) Anmelder: Siemens Aktiengesellschaft, 80333 München (DE)
(72) Erfinder: Hager, Alexander, 91056 Erlangen (DE); Kummer, Jürgen, 92224 Amberg (DE)

(57) **Zusammenfassung**

Es wird eine Verriegelungsvorrichtung für eine Tür offenbart, die einen Verriegelungsschieber, der zumindest in zwei Positionen verschiebbar ist, wobei in der ersten Position die Tür verriegelt ist und in der zweiten Position die Tür zum Öffnen freigegeben ist, und eine Führung, innerhalb derer der Verriegelungsschieber verschiebbar angeordnet ist, offenbart. Der Verriegelungsschieber umfasst eine Türabfrage, wobei die Türabfrage von der Tür zumindest in zwei Türabfrage-Positionen verstellbar ist, wobei in der ersten Türabfrage-Position bei geschlossener Tür der Verriegelungsschieber in eine seiner mindestens zwei Positionen verschoben werden kann und wobei in der zweiten Türabfrage-Position bei offener Tür der Verriegelungsschieber nicht in die erste Position zum Verriegeln der Tür verschoben werden kann.

## Beschreibung

Elektrische Schaltgeräte, wie Leistungsschalter, haben die Aufgabe, eine Anzahl von Verbrauchern von einem Spannungsversorgungsnetz abzukoppeln, wenn eine bestimmte Störung auftritt. Die klassische Störung ist das Auftreten eines Kurzschlussstroms, und die Leistungsschalter sind herkömmlicherweise dazu ausgelegt, bei einem solchen Kurzschlussstrom ein Schaltglied zu bewegen und so die Verbindung zwischen Verbrauchern und Netz zu entkoppeln.

Die Erfindung bezieht sich auf elektrische Schaltgeräte, insbesondere auf Leistungsschalter im Niederspannungsbereich. Mit Niederspannung sind typischerweise Spannungen von bis zu ca. 1000 Volt gemeint. Unter entsprechender konstruktiver Auslegung der Schalttrennstrecken können derartige Schaltgeräte auch für Schaltspannungen über 1000 Volt ausgelegt sein, wie zum Beispiel bis 6,3 kV. Insbesondere sind derartige elektrische Schaltgeräte, wie Niederspannungsleistungsschalter, zur Unterbrechung von Strombahnung in einem Überstromfall und/oder in einem Kurzschlussfall ausgebildet. Sie können einpolig oder mehrpolig, insbesondere dreipolig, ausgeführt sein.

Elektrische Schaltgeräte werden in der Regel in Schaltschränken angeordnet, damit diese geschützt sind. Üblicherweise ist ein solcher Schaltschrank im Bereich einer Maschine angeordnet, welcher durch das elektronische Innenleben des Schaltschranks gesteuert wird. Damit Unbefugten keinen Zugriff auf die elektrischen Schaltgeräte haben ist es bekannt, die Schaltschranktüren verriegelbar auszubilden. Zum Ein- und Ausschalten der elektrischen Schaltgeräte weisen diese Antriebe auf. Das heißt, die Antriebe sind an den elektrischen Schaltgeräten angeordnet und ermöglichen das Ein- und Ausschalten der elektrischen Schaltgeräte. Insbesondere werden dabei Antriebe verwendet, die zum Einschalten oder Ausschalten eines elektrischen Schaltgeräts zwischen einer Einschaltposition und einer Ausschaltposition bewegbar sind.

Als Antriebe sind beispielweise Direktantriebe, Türkupplungsdrehantriebe, Seitenwanddrehantriebe und Motorantriebe bekannt. Zum Schutz von Personen sind mechanische Türverriegelungen für Drehantriebe für elektrische Schaltgeräte, wie Niederspannungsschaltgeräte, bekannt. Dabei wird die mechanische Türverriegelung bei Direktantrieben als integraler Bestandteil des Direktantriebs als Teil des elektrischen Schaltgeräts gelöst. Bei Türkupplungsdrehantrieben ist die mechanische Türverriegelung als integraler Bestandteil des Kupplungselements zwischen Welle und Handhabe gelöst. Bei Seitenwanddrehantrieben ist keine mechanische Türverriegelung bekannt.

Bei eingeschalteten elektrischen Schaltgeräten sollte aus Sicherheitsgründen die Schaltschranktür verriegelt sein, damit ein Bediener nicht an spannungsführende Teile gelangen kann. Des Weiteren sollte die Verriegelung gewährleisten, dass das elektrische Schaltgerät nur bei geschlossener Schaltschranktür aktiviert werden kann.

Die Verriegelung von Schaltschranktüren erfolgt bisher durch Türkupplungsdrehantriebe, erweiterte Direktantriebe oder Direktantriebe. Damit diese Antriebe die Schaltschranktür verriegeln können, müssen diese direkt an oder hinter der Schaltschranktür angebracht werden. Bei einer entfernten Anordnung von elektrischem Schaltgerät beziehungsweise Antrieb des elektrischen Schaltgeräts und Schaltschranktür können sogenannte Ferntürverriegelungen verwendet werden. Problematisch hierbei ist, dass Ferntürverriegelungen bisher nicht erkennen können, ob die Schaltschranktür geöffnet oder geschlossen ist.

Es ist daher Aufgabe der vorliegenden Erfindung, die voranstehend beschriebenen Nachteile bekannter mechanischer Türverriegelungen für Antriebe von elektrischen Schaltgeräten zumindest teilweise zu beheben. Insbesondere ist es Aufgabe der Erfindung, eine flexible und von einem elektrischen Schaltgerät unabhängige mechanische Türverriegelung zu schaffen.

Diese Aufgabe wird erfindungsgemäß durch eine Verriegelungsvorrichtung für eine Tür mit den Merkmalen gemäß Anspruch 1 gelöst. Die Verriegelungsvorrichtung umfasst einen Verriegelungsschieber, der zumindest in zwei Positionen verschiebbar ist, wobei in der ersten Position die Tür verriegelt ist und in der zweiten Position die Tür zum Öffnen freigegeben ist und eine Führung, innerhalb derer der Verriegelungsschieber verschiebbar angeordnet ist, wobei der Verriegelungsschieber eine Türabfrage umfasst, wobei die Türabfrage von der Tür zumindest in zwei Türabfrage-Positionen verstellbar ist, wobei in der ersten Türabfrage-Position bei geschlossener Tür der Verriegelungsschieber in eine seiner mindestens zwei Positionen verschoben werden kann, und wobei in der zweiten Türabfrage-Position bei offener Tür der Verriegelungsschieber nicht in die erste Position zum Verriegeln der Tür verschoben werden kann.

Eine derartig ausgebildete Verriegelungsvorrichtung für eine Tür ist sehr flexibel einsetzbar und ist insbesondere unabhängig von der Position des elektrischen Schaltgeräts, wie beispielsweise ein Niederspannungsschaltgerät oder ein Kompaktleistungsschalter, in einem Schaltschrank. Die Verriegelungsvorrichtung stellt sicher, dass sie nur bei geschlossener Tür betätigt werden kann und die Tür verriegelt.

In einer Ausgestaltung der Verriegelungsvorrichtung ist die Türabfrage nur in der zweiten Position des Verriegelungsschiebers zwischen seinen mindestens zwei Türabfrage-Positionen verstellbar.

In einer weiteren Ausgestaltung der Verriegelungsvorrichtung umfasst die Türabfrage einen ersten Abschnitt und einen zweiten Abschnitt, wobei die Abschnitte unterschiedliche Durchmesser aufweisen und den beiden mindestens zwei Türabfrage-Positionen zugeordnet sind, und bei der die Führung eine Halterung für den Verriegelungsschieber umfasst, die einen Schlitz mit einer Schlitzöffnung aufweist, wobei in der zweiten Türabfrage-Position die Halterung dadurch das Verschieben des Verriegelungsschiebers verhindert, dass der ersten Abschnitt der Türabfrage nicht durch den Schlitz geführt werden kann, da der Durchmesser des ersten Abschnitts größer als der Schlitzdurchmesser ist, und wobei in der ersten Türabfrage-Position die Halterung dadurch das Verschieben des Verriegelungsschiebers ermöglicht, dass der zweite Abschnitt der Türabfrage durch den Schlitz geführt werden kann, da der Durchmesser des zweiten Abschnitts kleiner als der Schlitzdurchmesser ist.

In einer weiteren Ausgestaltung der Verriegelungsvorrichtung umfasst die Türabfrage zusätzlich eine Feder, die die Türabfrage in der zweiten Türabfrage-Position hält, in der der Verriegelungsschieber nicht in die erste Position zum Verriegeln der Tür verschoben werden kann. Dadurch wird sichergestellt, dass die Verriegelungsvorrichtung nicht betätigt werden kann, wenn die Tür geöffnet ist.

In einer weiteren Ausgestaltung der Verriegelungsvorrichtung verläuft der zweite Abschnitt der Türabfrage durch den Verriegelungsschieber und der erste Abschnitt der Türabfrage befindet sich an dem Ende des zweiten Abschnitts, welches von der Tür wegweist.

In einer weiteren Ausgestaltung der Verriegelungsvorrichtung umfasst die Verriegelungsvorrichtung zusätzlich ein Türelement, welches an der Tür angebracht ist, wobei in der ersten Position des Verriegelungsschiebers die Tür verriegelt, indem der Verriegelungsschieber das Türelement hintergreift, und welches in der zweiten Position des Verriegelungsschiebers die Tür zum Öffnen freigibt.

Die Aufgabe der Erfindung wird ebenfalls durch einen Schaltschrank mit den Merkmalen gemäß Anspruch 7 gelöst. Der Schaltschrank umfasst eine Schaltschranktür und eine erfindungsgemäße Verriegelungsvorrichtung, wobei die Tür der Verriegelungsvorrichtung von der Schaltschranktür gebildet wird.

In einer weiteren Ausgestaltung umfasst der Schaltschrank einen elektrischen Schalter mit einem Antrieb, wobei der elektrische Schalter mit der Verriegelungsvorrichtung so in Wirkverbindung steht, dass der elektrische Schalter nur geschaltet werden kann, wenn die Schaltschranktür geschlossen ist.

In einer Ausgestaltung des Schaltschranks stehen der elektrische Schalter mit dem Antrieb und die Verriegelungsvorrichtung über einen Bowdenzug in Wirkverbindung.

In einer weiteren Ausgestaltung des Schaltschranks wirkt das erste Ende des Bowdenzugs mit dem Schaltmechanismus des Antriebs zusammen und ist das zweite Ende des Bowdenzugs mit dem Verriegelungsschieber verbunden, so dass bei offener Schaltschranktür der elektrische Schalter nicht geschaltet werden kann, und bei geschlossener Schaltschranktür der elektrische Schalter geschaltet werden kann.

Die Erfindung wird im Weiteren anhand der nachfolgenden Figuren beschrieben.
- Fig. 1: Verriegelungsvorrichtung in Wirkverbindung mit einem elektrischen Schalter,
- Fig. 2: Verriegelungsvorrichtung mit Verriegelungsschieber in der zweiten Position zum Freigeben der Tür,
- Fig. 3: Verriegelungsvorrichtung gemäß Fig. 2 mit Türabfrage in der zweiten Türabfrage-Position, bei der der erste Abschnitt der Türabfrage nicht durch den Schlitz geführt werden kann,
- Fig. 4: Verriegelungsvorrichtung mit Türabfrage in der ersten Türabfrage-Position,
- Fig. 5: Verriegelungsvorrichtung mit Türabfrage in der ersten Türabfrage-Position, bei der der zweite Abschnitt der Türabfrage durch den Schlitz geführt werden kann, und
- Fig. 6A, 6B, 6C: Türabfrage mit ersten und zweiten Abschnitten, Verriegelungsschieber und Tür in einer ersten und in einer zweiten Türabfrage-Position.

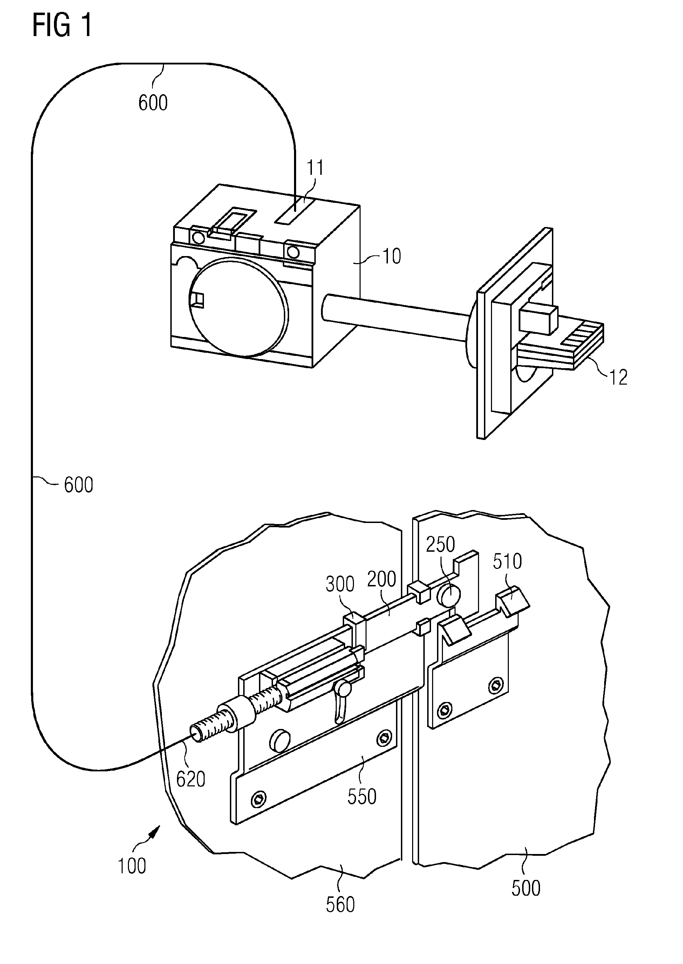

In Fig. 1 ist eine Verriegelungsvorrichtung 100 für eine Tür 500 dargestellt. Die Verriegelungsvorrichtung 100 umfasst einen Verriegelungsschieber 200, der zumindest in zwei Positionen verschiebbar ist, wobei in der ersten Position die Tür 500 verriegelt ist, und in der zweiten Position die Tür 500 zum Öffnen freigegeben ist. In der Fig. 1 befindet sich der Verriegelungsschieber 200 in der zweiten Position zum Freigeben der Tür 500. Die Verriegelungsvorrichtung 100 umfasst ferner eine Führung 300, innerhalb derer der Verriegelungsschieber 200 verschiebbar angeordnet ist.

Erfindungsgemäß umfasst der Verriegelungsschieber 200 eine Türabfrage 250, wobei die Türabfrage 250 von der Tür 500 zumindest in zwei Türabfrage-Positionen verstellbar ist. In der ersten Türabfrage-Position bei geschlossener Tür 500 kann der Verriegelungsschieber 200 in eine seiner mindestens zwei Positionen verschoben werden. In der zweiten Türabfrage-Position bei offener Tür 500 kann der Verriegelungsschieber 200 nicht in die erste Position vom Verriegeln der Tür 500 verschoben werden.

Die erfindungsgemäße Verriegelungsvorrichtung 100 kann Teil eines Schaltschranks sein, wobei die Tür 500 der Verriegelungsvorrichtung 100 von der Schaltschranktür gebildet wird. Der Schaltschrank kann einen elektrischen Schalter mit einem manuellen Antrieb 10 umfassen, wobei der Antrieb 10 mit einer Verriegelungsvorrichtung 100 so in Wirkverbindung steht, dass der elektrische Schalter nur geschaltet werden kann, wenn die Schaltschranktür geschlossen ist. Dazu stehen der elektrische Schalter und die Verriegelungsvorrichtung 100 über einen Bowdenzug 600 in Wirkverbindung. Das erste Ende des Bowdenzugs 600 wirkt mit dem manuellen Antrieb 10 des elektrischen Schalters zusammen. Das zweite Ende des Bowdenzugs 600 ist mit dem Verriegelungsschieber 200 verbunden, so dass bei offener Schaltschranktür der elektrische Schalter nicht geschaltet werden kann und bei geschlossener Schaltschranktür der elektrische Schalter geschaltet werden kann.

Der elektrische Schalter kann einerseits über einen Drehantrieb 10 mit Handhabe 12 betätigt werden. Andererseits ist ebenso denkbar, dass die Handhabe 12 auf dem elektrischen Schalter direkt angebracht ist. Der elektrische Schalter kann am Rand des Gehäuses des Schaltschranks untergebracht sein, so dass die Handhabe vom Benutzer betätigt werden kann. Ebenso kann der elektrische Schalter automatisch mittels eines Motors betrieben werden.

Der Bowdenzug 600 wirkt direkt mit dem manuellen Antrieb 10 des elektrischen Schalters zusammen. Dies bedeutet, dass bei einer Betätigung des Schaltmechanismus der Bowdenzug betätigt wird. Beispielsweise kann der Bowdenzug dadurch verkürzt werden, dass der Schaltmechanismus des elektrischen Schalters von der Position "AUS" in die Position "EIN" überführt wird.

Das zweite Ende des Bowdenzugs 600 ist mit dem Verriegelungsschieber 200 verbunden. Dadurch, dass der Bowdenzug 600 durch die Betätigung des Schaltmechanismus des elektrischen manuellen Antriebs 10 beispielsweise verkürzt wird, wird der Verriegelungsschieber 200 nach links gezogen gemäß der Darstellung in Fig. 1.

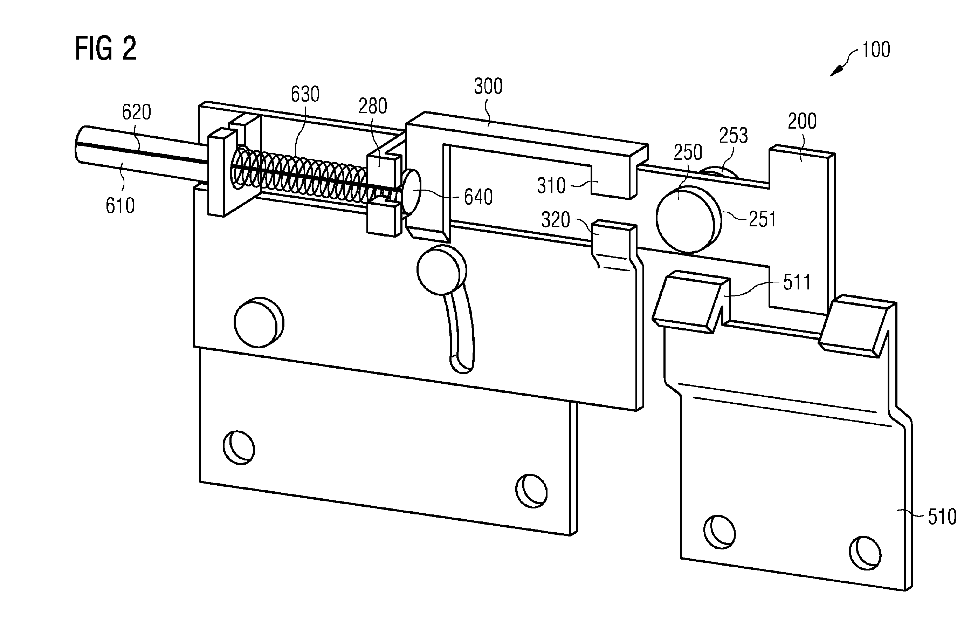

In Fig. 2 ist die Verriegelungsvorrichtung 100 mit dem Verriegelungsschieber 200 in der zweiten Position dargestellt, in der die Tür 500 zum Öffnen freigegeben ist. Das zweite Ende des Bowdenzugs 600 ist mit dem Verriegelungsschieber 200 verbunden. Der Bowdenzug 600 umfasst eine Seele 620, die beispielsweise aus Stahl gefertigt sein kann. Am Ende der Stahlseele 620 ist ein Nippel 640, der in die Öse 280 des Verriegelungsschiebers 200 eingehängt ist. Des Weiteren umfasst der Bowdenzug eine Hülle 610 zur mechanischen Führung der Bowdenzugseele 620. Es kann eine Feder 630 vorgesehen sein, die den Verriegelungsschieber 200 in der zweiten Position hält, in der die Tür 500 zum Öffnen freigegeben ist. Feder 630 ist beispielsweise eine Druckfeder.

Der Verriegelungsschieber 200 wird von einer Führung 300 gehalten, innerhalb derer der Verriegelungsschieber 200 verschiebbar angeordnet ist. Die Führung 300 weist einen Schlitz mit einer Schlitzöffnung auf, der von den Elementen 310, 320 gebildet wird. Der Schlitz mit seiner Schlitzöffnung wirkt mit der Türabfrage 250 zusammen.

Die Türabfrage 250 umfasst einen ersten Abschnitt 251 und einen zweiten Abschnitt 252, der in Fig. 2 nicht dargestellt ist. In der in Fig. 2 dargestellten zweiten Türabfrage-Position bei offener Tür 500 liegt der erste Abschnitt 251 auf dem Verrieglungsschieber 200 auf. Bei einer Betätigung des Bowdenzugs wird der Verriegelungsschieber 200 nach links bewegt. Dies ist aber nur so weit möglich, als dass die Halterung 300 mit dem Schlitz gebildet von den Elementen 310, 320 das Verschieben des Verriegelungsschiebers 200 verhindert beziehungsweise blockiert, weil der erste Abschnitt 251 der Türabfrage 250 nicht durch den Schlitz geführt werden kann, da der Durchmesser des ersten Abschnitts 251 größer als der Schlitzdurchmesser ist. Mechanisch wird durch die Türabfrage 250 die Bewegung des Verrieglungsschiebers 200 verhindert.

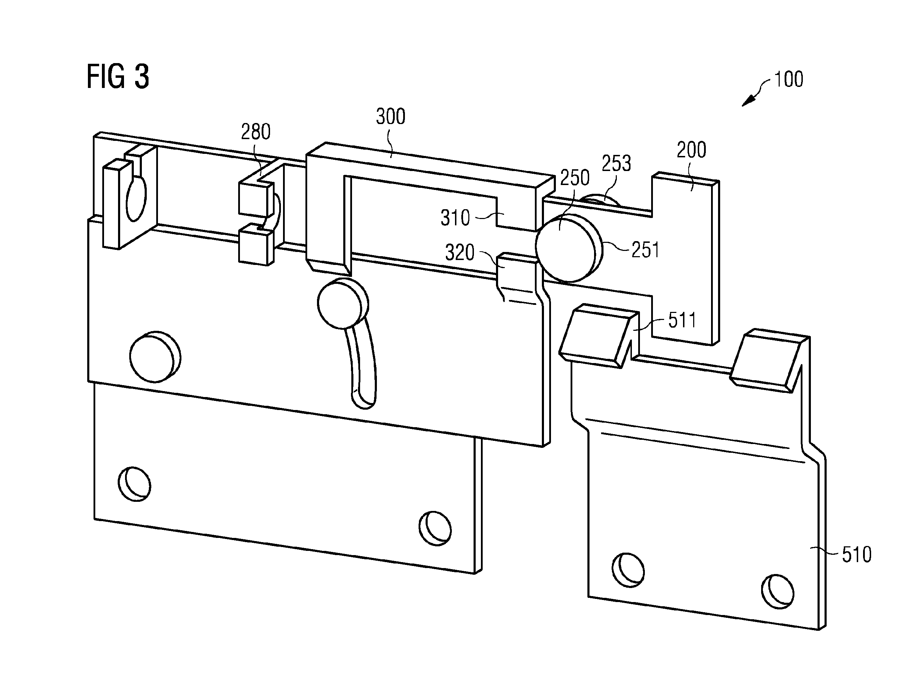

In Fig. 3 ist dargestellt, wie der Verriegelungsschieber 200 durch den Bowdenzug nach links bewegt wurde bis zu dem Punkt, an dem der erste Abschnitt 251 den Schlitz gebildet von den Elementen 310, 320 berührt und nicht durch den Schlitz geführt werden kann, da der Durchmesser des ersten Abschnitts 251 größer als der Schlitzdurchmesser ist.

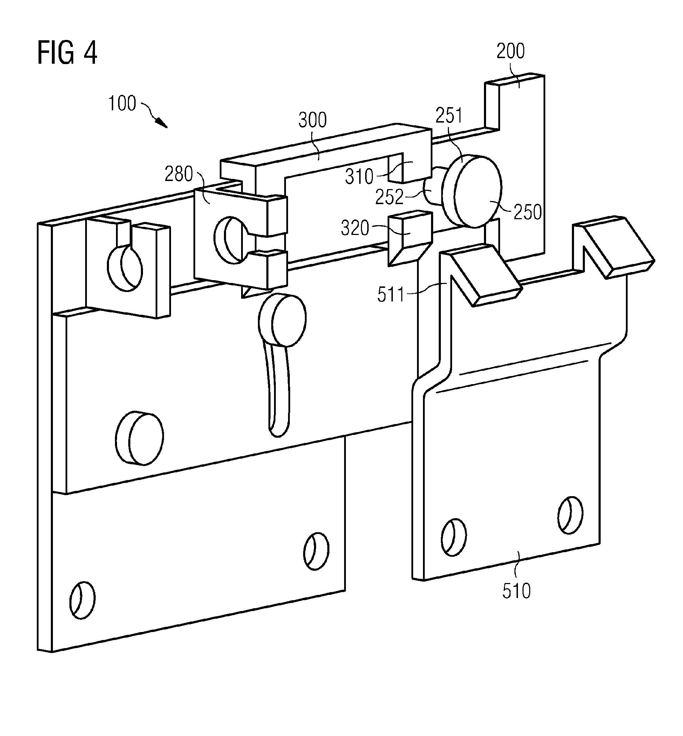

In Fig. 4 ist dargestellt, wie die Türabfrage 250 von der Tür 500 in die erste Türabfrage-Position übergeführt wurde. In der ersten Türabfrage-Position bei geschlossener Tür 500 kann der Verriegelungsschieber 200 in die erste Position, in der die Tür 500 verriegelt ist, und in die zweite Position, in der die Tür 500 zum Öffnen freigegeben ist, übergeführt werden. Der zweite Abschnitt 252 ist so ausgebildet, dass die Türabfrage 250 durch den Schlitz gebildet von den Elementen 310, 320 geführt werden kann, da der Durchmesser des zweiten Abschnitts 252 kleiner als der Schlitzdurchmesser ist. Die Türabfrage 250 kann so ausgebildet sein, dass sie nur in der zweiten Position des Verriegelungsschiebers 200, in der die Tür 500 zum Öffnen freigegeben ist, zwischen seinen mindestens zwei Türabfrage-Positionen verstellbar ist.

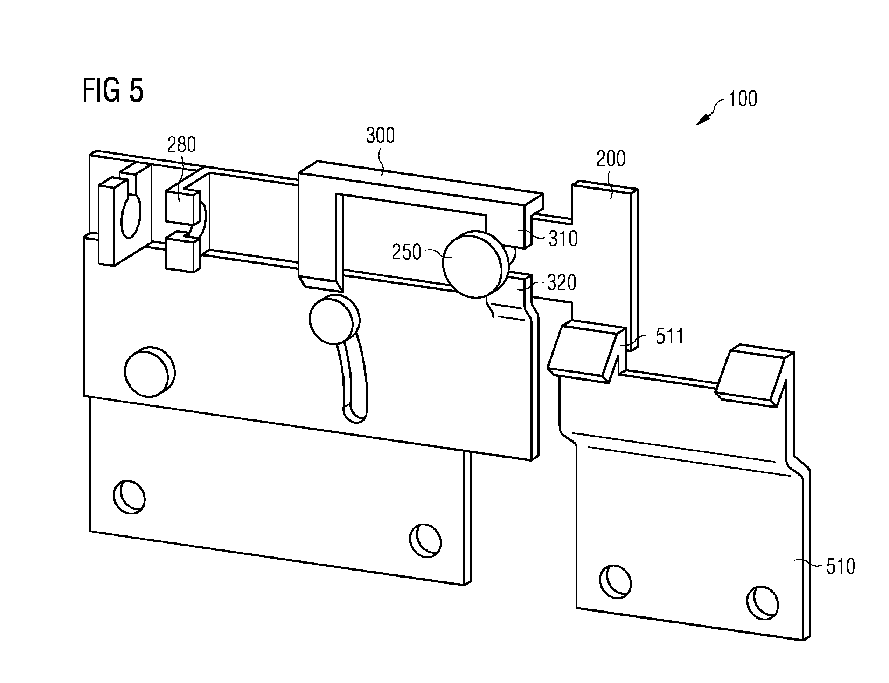

In Fig. 5 ist der Verriegelungsschieber 200 in die erste Position verschoben, in der die Tür 500 verriegelt ist. Die Türabfrage 250 befindet sich in der ersten Türabfrage-Position, so dass der zweite Abschnitt 252 mit dem Schlitz der Halterung 300 zusammenwirkt und durch die Elemente 310, 320 durchgeführt werden kann, da der Durchmesser des zweiten Abschnitts 252 kleiner als der Schlitzdurchmesser ist.

Die Verriegelungsvorrichtung 100 umfasst zusätzlich ein Türelement 510, welches an der Tür 500 angebracht ist, wobei in der ersten Position des Verriegelungsschiebers 200 die Tür 500 verriegelt, indem der Verriegelungsschieber 200 das Türelement 510 hintergreift. Dies ist entsprechend in Fig. 5 dargestellt. Der Verriegelungsschieber 200 hintergreift das Element 511 des Türelements 510.

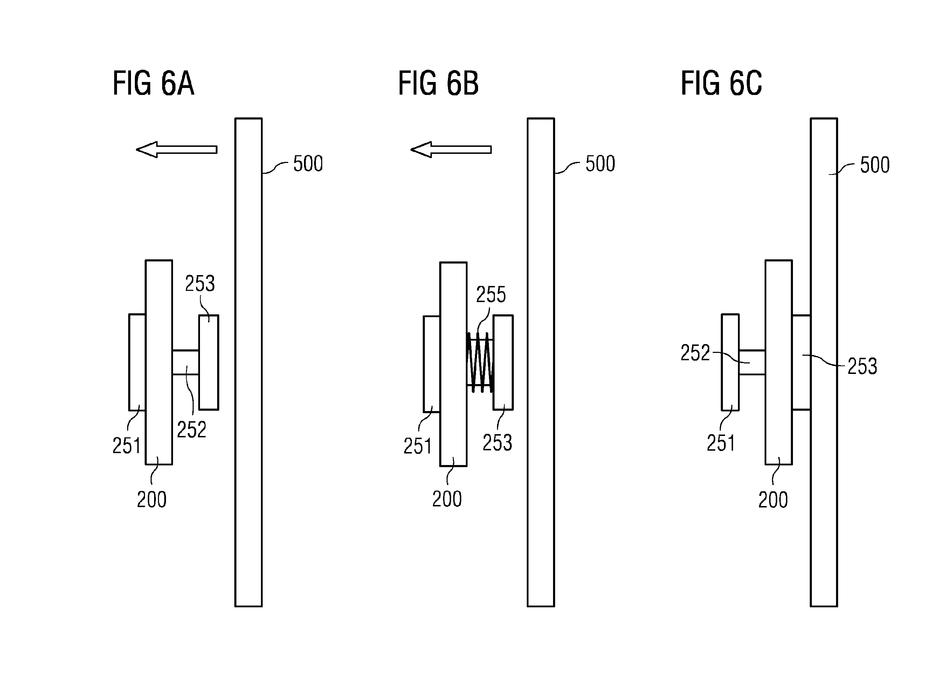

In den Fig. 6A, 6B, 6C ist die Türabfrage 250 mit erstem Abschnitt 251 und zweiten Abschnitt 252 dargestellt, sowie der Verriegelungsschieber 200 und die Tür 500.

In Fig. 6A ist die Türabfrage 250 in der zweiten Türabfrage-Position bei offener Tür 500 dargestellt. Tür 500 berührt die Türabfrage 250 nicht und bewegt sich zum Schließen entlang der Pfeil-Richtung. Die Türabfrage 250 wird von einem ersten Abschnitt 251, einem zweiten Abschnitt 252 und einem dritten Abschnitt 253 gebildet. Der dritten Abschnitt 253 ist der Tür 500 zugewendet, während der erste Abschnitt 251 mit der Halterung 300 und den Element 310, 320 der Halterung 300 zusammenwirkt. Der zweite Abschnitt 252 der Türabfrage 250 verläuft durch den Verriegelungsschieber 200, und der erste Abschnitt 251 der Türabfrage 250 befindet sich an dem Ende des zweiten Abschnitts 252, welches von der Tür 500 wegweist. Der dritte Abschnitt 253 der Türabfrage 250 befindet sich an dem Ende des zweiten Abschnitts 252, welches zur Tür 500 hinweist.

In der zweiten Türabfrage-Position bei offener Tür 500 liegt der erste Abschnitt 251 auf dem Verriegelungsschieber 200 auf. Ebenfalls ist denkbar, dass in dieser Position ein Spalt zwischen dem ersten Abschnitt 251 der Türabfrage 250 und dem Verriegelungsschieber 200 ist. Dadurch, dass der Schlitz in der Halterung 300 ebenfalls mit dem Verriegelungsschieber 200 direkt zusammenwirkt, kann in der zweiten Türabfrage-Position der Verriegelungsschieber nicht in die erste Position zur Verriegelung der Tür 500 übergeführt werden.

Gemäß Fig. 6B kann die Türabfrage 250 zusätzlich eine Feder 255 umfassen, die die Türabfrage 250 in der zweiten Türabfrage-Position hält, in der die Tür 500 nicht verriegelt werden kann.

In Fig. 6C ist dargestellt, wie die Türabfrage 250 von der Tür 500, die entsprechend der Pfeil-Richtung in den Fig. 6A und 6B geschlossen wurde, betätigt wurde. Durch die Tür 500 wird die Türabfrage 250 betätigt, dies bedeutet, dass der dritte Abschnitt 253, der von der Tür 500 berührt wird, nach links verschoben wird. Dadurch werden auch der erste Abschnitt 251 und der zweite Abschnitt 252 nach links bewegt. Der erste Abschnitt 251 berührt nun nicht mehr den Verriegelungsschieber 200. In der nun erreichten ersten Türabfrage-Position bei geschlossener Tür 500 kann der Verriegelungsschieber 200 in eine seiner mindestens zwei Positionen verschobene werden. In dieser ersten Türabfrage-Position kann der zweite Abschnitt 252 der Türabfrage 250 durch den Schlitz geführt werden, der von den Elementen 310, 320 der Halterung 300 gebildet wird, da der Durchmesser des zweiten Abschnitts 252 kleiner als der Schlitzdurchmesser ist.

Die erfindungsgemäße Verriegelungsvorrichtung 100 und der Schaltschrank umfassend die erfindungsgemäße Verriegelungsvorrichtung 100 ermöglichen, dass ein elektrischer Schalter nur bei geschlossener Tür eingeschaltet werden kann und die Tür gleichzeitig verriegelt wird.

## Patentansprüche

1. Verriegelungsvorrichtung (100) für eine Tür (500) umfassend einen Verriegelungsschieber (200), der zumindest in zwei Positionen verschiebbar ist, wobei in der ersten Position die Tür (500) verriegelt ist und in der zweiten Position die Tür (500) zum Öffnen freigegeben ist, und eine Führung (300), innerhalb derer der Verriegelungsschieber (200) verschiebbar angeordnet ist, **dadurch gekennzeichnet, dass** der Verriegelungsschieber (200) eine Türabfrage (250) umfasst, wobei die Türabfrage (250) von der Tür (500) zumindest in zwei Türabfrage-Positionen verstellbar ist, wobei in der ersten Türabfrage-Position bei geschlossener Tür (500) der Verriegelungsschieber (200) in eine seiner mindestens zwei Positionen verschoben werden kann und wobei in der zweiten Türabfrage-Position bei offener Tür (500) der Verriegelungsschieber (200) nicht in die erste Position zum Verriegeln der Tür (500) verschoben werden kann.

2. Verriegelungsvorrichtung (100) für eine Tür (500) gemäß Anspruch 2, bei der die Türabfrage (250) nur in der zweiten Position des Verriegelungsschiebers (200) zwischen seinen mindestens zwei Türabfrage-Positionen verstellbar ist.

3. Verriegelungsvorrichtung (100) für eine Tür (500) gemäß Anspruch 1 oder 2, bei der die Türabfrage (250) einen ersten Abschnitt (251) und einen zweiten Abschnitt (252) umfasst, wobei die Abschnitte (251; 252) unterschiedliche Durchmesser aufweisen und den beiden mindestens zwei Türabfrage-Positionen zugeordnet sind und bei der die Führung (300) eine Halterung (310; 320) für den Verriegelungsschieber (200) umfasst, die einen Schlitz mit einer Schlitzöffnung aufweist, wobei in der zweiten Türabfrage-Position die Halterung dadurch das Verschieben des Verriegelungsschiebers (200) verhindert, dass der erste Abschnitt (251) der Türabfrage (250) nicht durch den Schlitz geführt werden kann, da der Durchmesser des ersten Abschnitts (251) größer als der Schlitzdurchmesser ist und wobei in der ersten Türabfrage-Position die Halterung dadurch das Verschieben des Verriegelungsschiebers (200) ermöglicht, dass der zweite Abschnitt (252) der Türabfrage (250) durch den Schlitz geführt werden kann, da der Durchmesser des zweiten Abschnitts (252) kleiner als der Schlitzdurchmesser ist.

4. Verriegelungsvorrichtung (100) für eine Tür (500) gemäß Anspruch 3, bei der die Türabfrage (250) zusätzlich eine Feder (255) umfasst, die die Türabfrage (250) in der zweiten Türabfrage-Position hält, in der der Verriegelungsschieber (200) nicht in die erste Position zum Verriegeln der Tür (500) verschoben werden kann.

5. Verriegelungsvorrichtung (100) für eine Tür (500) gemäß Anspruch 3 oder 4, bei der der zweite Abschnitt (252) der Türabfrage (250) durch den Verriegelungsschieber (200) verläuft und der erste Abschnitt (251) der Türabfrage (250) sich an dem Ende des zweiten Abschnitts (252) befindet, welches von der Tür (500) wegweist.

6. Verriegelungsvorrichtung (100) für eine Tür (500) gemäß einem der vorherigen Ansprüche, umfassend zusätzlich ein Türelement (510), welches an der Tür (500) angebracht ist, wobei in der ersten Position des Verriegelungsschiebers (200) die Tür (500) verriegelt indem der Verriegelungsschieber (200) das Türelement (510) hintergreift, und welches in der zweiten Position des Verriegelungsschiebers (200) die Tür (500) zum Öffnen freigibt.

7. Schaltschrank umfassend eine Schaltschranktür und eine Verriegelungsvorrichtung (100) gemäß einem der vorherigen Ansprüche, wobei die Tür (500) der Verriegelungsvorrichtung (100) von der Schaltschranktür gebildet wird.

8. Schaltschrank gemäß Anspruch 7, umfassend einen elektrischen Schalter mit einem Antrieb (10), wobei der elektrische Schalter mit der Verriegelungsvorrichtung (100) so in Wirkverbindung steht, dass der elektrische Schalter nur geschaltet werden kann, wenn die Schaltschranktür geschlossen ist.

9. Schaltschrank gemäß Anspruch 7 oder 8, bei dem der elektrische Schalter mit dem Antrieb (10) und die Verriegelungsvorrichtung (100) über einen Bowdenzug (600) in Wirkverbindung stehen.

10. Schaltschrank gemäß Anspruch 9, bei dem das erste Ende des Bowdenzugs (600) mit dem Schaltmechanismus des Antriebs (10) zusammenwirkt und das zweite Ende des Bowdenzugs (600) mit dem Verriegelungsschieber (200) verbunden ist, so dass bei offener Schaltschranktür der elektrische Schalter nicht geschaltet werden kann und bei geschlossener Schaltschranktür der elektrische Schalter geschaltet werden kann.
